# EUROPEAN PATENT APPLICATION

(11) **EP 4 808 145 A1**
(43) Date of publication of application: **16.09.2026**
(21) Application number: 24889035.2
(22) Date of filing: 01.11.2024
(51) Int. Cl.: H04N 25/773, H04N 25/42, H10F 39/00

(54) **SPAD-BASED IMAGE SENSOR AND METHOD FOR OPERATING SAME**

(30) Priority: 06.11.2023 KR 20230151593
(71) Applicant: XO Semiconductor Inc., Chuncheon-si, Gangwon-do 24329 (KR)
(72) Inventor: CHAE, Youngcheol, Seoul 06276 (KR); PARK, Byungchoul, Seoul 06298 (KR)
(74) Representative: Jung, Minkyu
(86) International application number: PCT/KR2024/016982
(87) International publication number: WO 2025/100847

(57) **Abstract**

Proposed are an image sensor, and an operation method thereof. The image sensor includes a pixel array including multiple pixels, wherein each of the multiple pixels includes an SPAD configured to detect photons to generate impulse signals, a counter configured to count the number of pulse signals applied, a multiplexer configured to select one count bit cell among multiple count bit cells of the counter according to a mode selection signal, and output an overflow signal according to a bit value of the selected count bit cell, and a front-end module configured to convert the impulse signals to the pulse signals, and convert global clock signals to the pulse signals and forward the pulse signals to the counter when the overflow signal is applied. Accordingly, light can be detected with ultra-high precision at low power, and the section with extrapolation is applied is variable to detect light with adjustable precision.

## Description

### Technical Field

The present disclosure relates to an image sensor and an operation method thereof and, more particularly, to an SPAD-based image sensor and an operation method thereof.

### Background Art

An image sensor is an apparatus that obtains an image by detecting incident light and converting the same to an electrical signal, and may include various sensing devices capable of detecting light. As conventional light-sensing devices, CMOS devices or CCD devices have been mainly used. However, due to an increasing demand for an optical sensor with ultra-high sensitivity, a single-photon avalanche diode (hereinafter, referred to as SPAD) device capable of directly detecting a single photon, which is the smallest unit of light, has been developed recently, and research on an image sensor using a SPAD device has been widely carried out.

A SPAD device can detect light with ultra-high sensitivity by being triggered by even a single photon as a reverse bias voltage equal to or greater than a breakdown voltage is applied thus causing the avalanche breakdown phenomenon. When photons are detected and the avalanche breakdown phenomenon occurs, temporary large current flows and the SPAD device outputs an impulse waveform signal. Further, after outputting an impulse signal, the SPAD device is quenched and returns to its previous state. Therefore, an SPAD-based image sensor counts the number of impulse signals output from an SPAD device in each pixel and detects the intensity of incident light, thereby obtaining an image. That is, if many photons are incident and the counted number of impulse signals is large, a bright image is obtained. If the counted number of impulse signals is small, a dark image is obtained.

In an SPAD-based image sensor, each pixel includes an SPAD device as well as a counter for counting the number of impulse signals generated by the SPAD device. Herein, the count range and the number of bits of the counter are determined in advance according to the purpose of use of the image sensor.

In the SPAD-based image sensor, an SPAD device operates using the avalanche breakdown phenomenon caused as a reverse bias voltage of a high voltage is applied as described above, which results in large power consumption each time an impulse signal is generated. That is, detecting a bright image in which a large number of impulse signals are repeatedly generated causes very high power consumption.

In addition, an image sensor needs to be able to detect the intensity of light in various ranges varying according to the field of application, but in a conventional SPAD-based image sensor, the number of bits of a counter is fixed and determined. Thus, it is necessary to individually manufacture image sensors including counters having different numbers of bits according to the purpose of use, which increases manufacturing costs.

The present invention is derived from research conducted as part of the Ministry of Science and ICT's "Development of a Global Shutter-based 20 x 20 cm Large-Area Hybrid X-ray Video Detector" (Project Unique No.: 1711194204, Project No.: KD000048, Research Project Name: Pan-Ministerial Full-Cycle Medical Device Research and Development (MSIT), Project Management Agency: Pan-Ministerial Full-Cycle Medical Device Research and Development Foundation, Project Executing Agency: Rayence Co., Ltd., Research Period: 2023.01.01 ~ 2023.12.31).

Meanwhile, the Korean government, the entity providing the project, has no property interest in any aspect of the present invention.

### Disclosure

### Technical Problem

The present disclosure is directed to providing an image sensor and an operation method thereof that are capable of reducing power consumption and detecting light with ultra-high precision.

The present disclosure is directed to providing an image sensor and an operation method thereof that are capable of detecting light with adjustable precision according to purpose.

### Technical Solution

According to an embodiment of the present disclosure, there is provided an image sensor including: a pixel array including multiple pixels, wherein each of the multiple pixels includes: an SPAD configured to detect photons to generate impulse signals; a counter configured to count the number of pulse signals applied; a multiplexer configured to select one count bit cell among multiple count bit cells of the counter according to a mode selection signal, and output an overflow signal according to a bit value of the selected count bit cell; and a front-end module configured to convert the impulse signals to the pulse signals, and convert global clock signals to the pulse signals and forward the pulse signals to the counter when the overflow signal is applied.

The front-end module may be configured to run the SPAD during a light detection operation, and stop the running of the SPAD when the overflow signal is applied.

The front-end module may be configured to convert the impulse signals or the global clock signals applied until the end of a set exposure time to the pulse signals and forward the pulse signals to the counter during a light detection operation.

The front-end module may be configured to receive the global clock signals in response to the overflow signal once until the end of a set exposure time.

The front-end module may be configured to initialize the counter after a set exposure time.

The multiplexer may be implemented included in either the front-end module or the counter.

The image sensor may further include a control module, wherein the control module may be configured to generate the mode selection signal, and receive a count value from the counter to obtain a pixel value after a set exposure time.

The control module may be configured to obtain the number of overflows and an overflow time from the count value according to the count bit cell of the counter selected according to the mode selection signal, and calculate and obtain the pixel value according to extrapolation on the basis of the number of overflows and the overflow time obtained and the exposure time.

The control module may be configured to select one among multiple timing-gain tables in which pixel values according to respective count values are calculated and stored in advance, according to the selected count bit cell, and then obtain the pixel value by searching the selected timing-gain table for the pixel value corresponding to the count value.

The control module may be configured to generate the mode selection signal by independently setting the count bit cell selected in each of the multiple pixels.

According to another embodiment of the present disclosure, there is provided an operation method of an image sensor including a pixel array of multiple pixels each including an SPAD and a counter, and a control module, the operation method including: generating a mode selection signal for selecting one count bit cell for outputting an overflow signal among multiple count bit cells of the counter; running the SPAD to count the number of impulse signals generated according to detected photons; generating the overflow signal in response to a bit value of the count bit cell selected according to the mode selection signal in the counter; and counting global clock signals when the overflow signal is generated.

### Advantageous Effects

According to the present disclosure, the image sensor and the operation method thereof can estimate, on the basis of extrapolation, the number of impulse signals generated by the SPAD device without continuously counting the number thereof during the exposure time, thereby reducing the run time of the SPAD device and detecting light with ultra-high precision at low power. In addition, the section to which extrapolation is applied varies according to the purpose of use, thereby detecting light with adjustable precision.

### Description of Drawings

FIG. 1 shows the schematic configuration of an SPAD-based image sensor.
FIG. 2 shows the schematic configuration of a pixel of FIG. 1.
FIG. 3 shows the schematic configuration of a pixel according to an embodiment.
FIG. 4 is a diagram illustrating extrapolation applied to an SPAD-based image sensor having a pixel of FIG. 3.
FIG. 5 shows the schematic configuration of a pixel according to another embodiment.
FIG. 6 shows an operation method of an SPAD-based image sensor according to an embodiment.

### Mode for Invention

Hereinafter, a specific example according to an embodiment of the present disclosure will be described with reference to the accompanying drawings. The following detailed description is provided to help a comprehensive understanding of a method, an apparatus, and/or a system described herein. However, this is only an example, and the present disclosure is not limited thereto.

In describing embodiments of the present disclosure, if it is determined that a detailed description of the known art related to the present disclosure make the subject matter of the embodiments unclear, the detailed description will be omitted. Further, the terms described below are defined in consideration of the functions in the present disclosure, which may vary depending on the intention of the user, the operator, or the custom. Therefore, the definition should be based on the contents throughout this specification. The terminology used in the detailed description is provided only to describe embodiments of the present disclosure and not for purposes of limitation. Unless the context clearly indicates otherwise, the singular forms include the plural forms. In this description, the expressions such as "includes" or "has" specify some features, numbers, steps, operations, elements, parts, or combinations thereof, and should not be construed to preclude the presence or possibility of one or more other features, numbers, steps, operations, elements, parts, or combinations thereof. Also, the terms "~ part", "~ unit", "~module", "~ block", and the like mean a unit for processing at least one function or operation and may be implemented by hardware or software or a combination thereof.

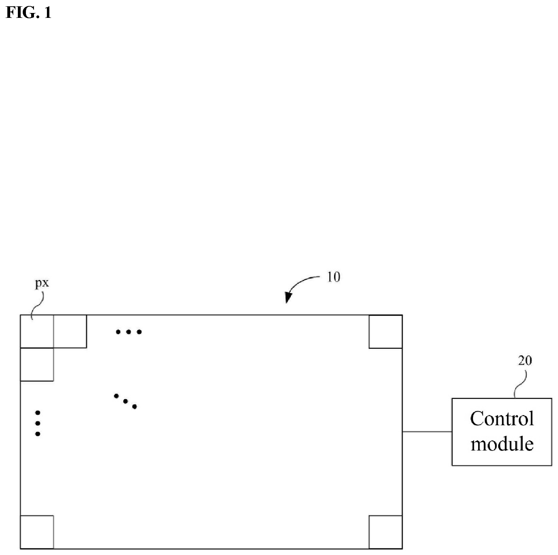

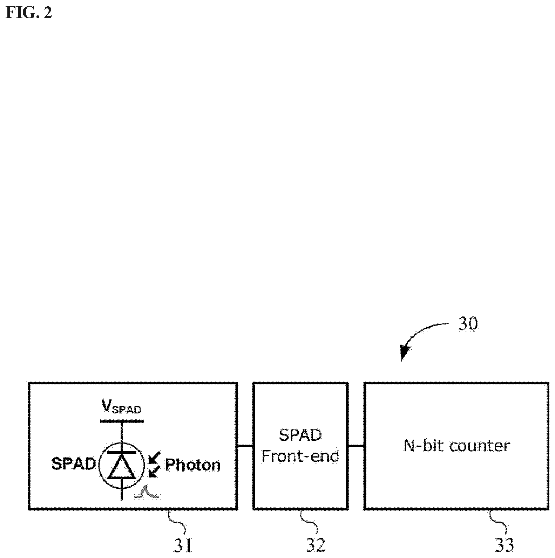

FIG. 1 shows the schematic configuration of an SPAD-based image sensor. FIG. 2 shows the schematic configuration of a pixel of FIG. 1.

Referring to FIG. 1, an SPAD-based image sensor includes a pixel array 10 and a control module 20. The pixel array 10 includes multiple pixels (px) arranged in an array, which may include an array of M × N pixels (px), for example. FIG. 2 shows an example of the configuration of one pixel 30 among the multiple pixels (px) of the pixel array 10 of FIG. 1.

The pixel 30 shown in FIG. 2 may include an SPAD 31, a front-end module 32, and a counter 33.

The SPAD 31 may be implemented as an avalanche diode that operates in a Geiger mode as a reverse bias voltage (V_{SPAD}) (for example, 23 V) equal to or greater than a breakdown voltage is applied. The SPAD 31 may generate an impulse signal as the avalanche breakdown phenomenon occurs in ultra-sensitive reaction to photons.

The front-end module 32 may control the running of the SPAD 31 under the control of the control module 20, and may convert an impulse signal output from the running SPAD 31 to a pulse signal and forward the pulse signal to the counter 33.

For example, the front-end module 32 applies an operation control voltage of a particular level to the anode end of the SPAD 31 under the control of the control module 20 such that the voltage difference between the opposite ends of the SPAD 31 is equal to or less than the breakdown voltage, thereby preventing the SPAD 31 from running. However, the method of controlling the running of the SPAD 31 may be variously changed.

In addition, the front-end module 32 may perform level shifting such that a pulse signal has a lower voltage level than an impulse signal, and may forward the pulse signal to the counter 33. As described above, when a reverse bias voltage (V_{SPAD}) of a high voltage (for example, 23 V) is applied and incident photons occur the avalanche breakdown phenomenon, the SPAD 31 may generate an impulse signal of a high voltage. To prevent such an impulse signal from being forwarded to as it is the counter 33, the front-end module 32 may level-shift the impulse signal of the applied high voltage to a low voltage level (for example, 3 V) and convert the impulse signal to a pulse signal and forward the pulse signal to the counter 33.

Additionally, the front-end module 32 may enable the SPAD 31 at which the avalanche breakdown phenomenon has occurred to be quickly quenched and to return to its previous state, and may reset the counter 33 to initialize a pixel value counted by the counter 33.

The front-end module 32 may include multiple switches, which are implemented as transistors, multiple logic devices, and a level shift circuit, but the elements and circuit configuration constituting the front-end module 32 may be variously designed and will not be described in detail.

The counter 33 counts the number of pulse signals applied from the front-end module 32 to obtain a pixel value resulting from measuring the amount of light (or the intensity of light) incident to the pixel 30. Herein, the counter 33 may be implemented as an N-bit counter, and the number (N) of bits of the counter 33 may be preset in advance according to the purpose of use of the image sensor.

The control module 20 controls the front-end module 32 of each of the multiple pixels (px) of the pixel array 10 to control the running of the SPAD 31 included in each pixel (px). As example, the control module 20 may enable the multiple pixels (px) of the pixel array 10 to detect light simultaneously or on a per-row or column basis. In some cases, only some of the multiple pixels (px) of the pixel array 10 may detect light selectively according to various combinations. In addition, the control module 20 may control the front-end module 32 to adjust the exposure time, which refers to the time during which each of the multiple pixels (px) detects photons.

In addition, the control module 20 may construct an image by receiving a pixel value forwarded from the counter 33 for each pixel. That is, the control module 20 may operate as a control circuit for controlling the pixel array 10 as well as an image processing circuit.

The SPAD 31, the front-end module 32, and the counter 33 may all be implemented on the same layer. In some cases, the SPAD 31, the front-end module 32, and the counter 33 may be implemented on different layers.

In the case of the pixel shown in FIG. 2, since the number (N) of bits of the counter 33 is set in advance and fixed, the pixel values that may be output from each pixel 30 range from 0 to 2^{N}-1.

Therefore, the number of impulse signals the SPAD 31 of each of the multiple pixels 30 generates until the end of the exposure time is not limited, but the counter 33 may count at most 2^{N}-1 impulse signals. Accordingly, when the value counted by the counter 33 reaches the maximum value (2^{N}-1), the front-end module 32 prevents the SPAD 31 from running, thereby reducing power consumption.

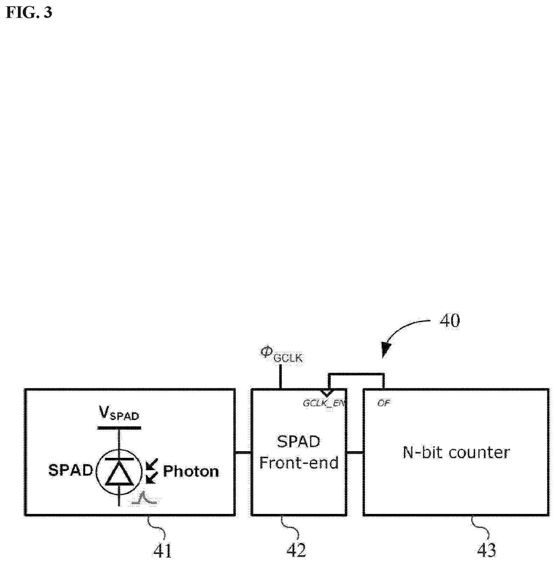

FIG. 3 shows the schematic configuration of a pixel according to an embodiment.

FIG. 3 also shows an example of the configuration of each of the multiple pixels (px) included in the pixel array 10 in the image sensor shown in FIG. 1. As in FIG. 2, also, the pixel 40 of FIG. 3 may include an SPAD 41, a front-end module 42, and a counter 43.

Herein, the SPAD 41 has the same configuration as the SPAD 31 of FIG. 2, and will not be described further. However, the front-end module 42 and the counter 43 may be configured differently from the front-end module 32 and the counter 33 of FIG. 2. Specifically, like the counter 33 of FIG. 2, the counter 43 may be fundamentally implemented as a counter of fixed N bits. However, in FIG. 3, when a value counted according to applied pulse signals is equal to or greater than a specified reference value, the counter 43 may forward an overflow signal (OF) to the front-end module 42. Herein, for example, a description will be made assuming that the counter 43 forwards the overflow signal (OF) to the front-end module 42 according to the bit value of the most significant bit (hereinafter, referred to as the MSB). That is, when the value counted by the N-bit counter 43 reaches 2^{N-1} and the MSB becomes 1, an overflow signal (OF) may be output to the front-end module 42. However, the bit position at which the overflow signal (OF) is output may be set in advance as a position varying according to the purpose of use.

In addition, when the overflow signal (OF) is applied from the counter 43, the front-end module 42 prevents the SPAD 41 from running. Therefore, the SPAD 41 no longer generates an impulse signal. However, the front-end module 42 may receive a global clock signal (φ_{GCLK}) instead of an impulse signal, and may forward a pulse signal to the counter 33 according to the received global clock signal (φ_{GCLK}). That is, when an overflow signal (OF) is applied, the front-end module front-end module 42 may generate a pulse signal according to a global clock signal (φ_{GCLK}) rather than an impulse signal and may forward the pulse signal to the counter 43.

Accordingly, the counter 43 counts the number of pulse signals generated according to the impulse signals generated by the SPAD 41, and then continuously counts the number of pulse signals generated according to the global clock signals (φ_{GCLK}). Since the N-bit counter 43, which is capable of counting values up to 2^{N}-1, has counted the value only up to 2^{N-1} for the pulses according to the impulse signals, the counter 43 may count the number of pulses according to global clock signals (φ_{GCLK}) for the remaining range of 2^{N-1}+1 to 2^{N}-1.

In addition, under the control of the control module 20, the front-end module 42 may forward pulse signals according to global clock signals (φ_{GCLK}) to the counter 43 until the end of the exposure time (T_{EXP}).

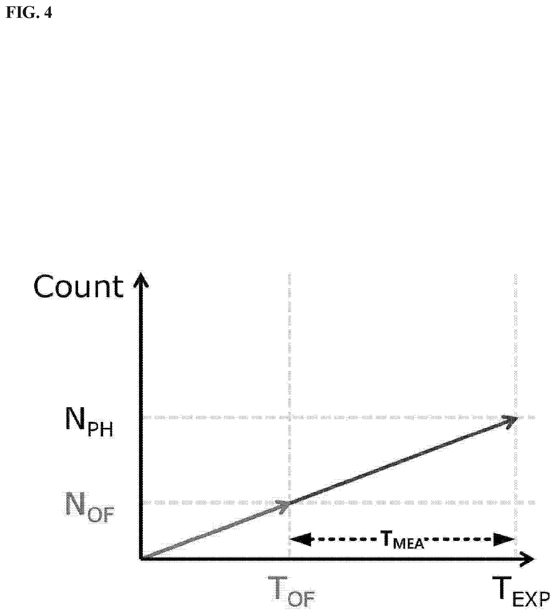

FIG. 4 is a diagram illustrating extrapolation applied to an SPAD-based image sensor having a pixel of FIG. 3.

When the multiple pixels (px) of the pixel array 10 are a plurality of the pixels 30 of FIG. 2, each pixel 30 obtains a pixel value (N_{PH}) by counting the number of incident photons during the preset exposure time (T_{EXP}) under the control of the control module 20.

Herein, it may be considered that the exposure time (T_{EXP}) is preset and at each pixel (px), photons are uniformly incident during the exposure time (T_{EXP}). Therefore, as shown in FIG. 4, although not all the incident photons during the exposure time (T_{EXP}) are counted, if the overflow time (T_{OF}), which is the time when the number of incident photons reaches a particular number (herein, for example, the number (N_{OF}) of overflows), is determined, the number of incident photons during the exposure time (T_{EXP}), that is, the pixel value (N_{PH}), may be easily estimated using a simple proportional expression according to extrapolation.

Referring to FIG. 4, the pixel value (N_{PH}) according to extrapolation may be calculated as shown in Equation 1.${N}_{PH} = {N}_{OF} * \left({T}_{EXP}/{T}_{OF}\right)$

In Equation 1, since the number (N_{OF}) of overflows and the exposure time (T_{EXP}) are preset, if the overflow time (T_{OF}) is determined, the pixel value (N_{PH}) may be easily calculated.

In addition, in the structure of the pixel 40 of FIG. 3, the overflow time (T_{OF}) is the time when an overflow signal (OF) is generated. However, in order to use a global clock signal (φ_{GCLK}) to directly measure the overflow time (T_{OF}) when an overflow signal (OF) is generated, a separate counter for counting the number of global clock signals (φ_{GCLK}) may be further required in addition to the counter 43 for counting the number of pulse signals according to impulse signals. However, since the exposure time (T_{EXP}) is preset, the time from the overflow time (T_{OF}) when an overflow signal (OF) is generated to the end of the exposure time (T_{EXP}) is measured (T_{MEA}) using global clock signals (φ_{GCLK}), and the measured time (T_{MEA}) is subtracted from the exposure time (T_{EXP}) (T_{EXP} - T_{MEA}), thereby easily calculating the overflow time (T_{OF}).

In addition, the above description has been made assuming that the counter 43 of the pixel 40 shown in FIG. 3 counts only the value up to 2^{N-1}, which is the number (N_{OF}) of overflows, according to impulse signals, so that afterward the number of pulses according to global clock signals (φ_{GCLK}) may be counted within the range of 2^{N-1}+1 to 2^{N}-1. That is, the counter 43 provided to count the number of impulse signals is recycled and used to count the number of clocks of the global clock signals (φ_{GCLK}) for determining the measurement time (T_{MEA}), after the overflow time (T_{OF}). Therefore, the pixel value (N_{PH}) may be estimated by applying extrapolation even with one counter 43.

The pixel value (N_{PH}) may be estimated by the control module 20 that receives a count value counted by the counter 43. Herein, the description has been made assuming that the counter 43 outputs an overflow signal (OF) according to the bit value of the MSB, so the control module 20 may determine the number of global clock signals (φ_{GCLK}) counted from the bit values excluding the MSB among the bit values output from the counter 43. In addition, the overflow time (T_{OF}) may be estimated from the number of global clock signals (φ_{GCLK}), and the estimated overflow time (T_{OF}) may be applied to Equation 1 to obtain the pixel value N_{PH}). However, the estimating of the pixel value (N_{PH}) for each of the multiple pixels (px) included in the pixel array 10 requires a large amount of computation and is thus inefficient. Accordingly, the control module 20 is configured to obtain the pixel value (N_{PH}) immediately by using a timing-gain table in which pixel values (N_{PH}) according to count values are calculated and stored in advance, thereby greatly reducing the amount of computation.

In the pixel 40 of FIG. 4, the front-end module 42 prevents the SPAD 41 from running during the time from the overflow time (T_{OF}) to the end of the exposure time (T_{EXP}), so that the power consumption of the pixel array 10 may be significantly reduced.

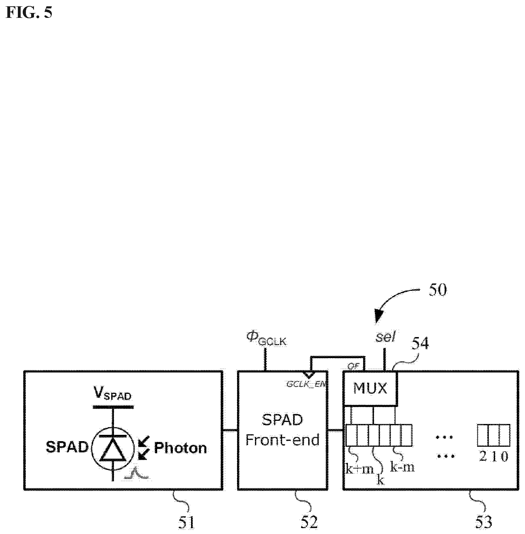

FIG. 5 shows the schematic configuration of a pixel according to another embodiment.

Like the pixel 40 of FIG. 4, also, a pixel 50 of FIG. 5 may fundamentally include an SPAD 51, a front-end module 52, and a counter 53. The SPAD 51 and the front-end module 52 may be operated in the same manner as the SPAD 41 and the front-end module 42 included in the pixel 40 of FIG. 4.

That is, the SPAD 51 runs under the control of the front-end module 52 and outputs impulse signals caused by the avalanche breakdown phenomenon when photons are detected. In addition, the front-end module 52 controls the running of the SPAD 51, and converts an impulse signal applied from the SPAD 51 to a pulse signal and forwards the pulse signal to the counter 53. In addition, when an overflow signal (OF) is applied from the counter 53, the SPAD 51 does not run. Until the end of the exposure time (T_{EXP}), a global clock signal (φ_{GCLK}) is received, and a pulse signal according to the global clock signal (φ_{GCLK}) is forwarded to the counter 53.

Like the counters 33 and 43 of FIGS. 2 and 4, the counter 43 is implemented as an N-bit counter capable of counting an N-bit value, and may count the number of pulse signals forwarded from the front-end module 52. In addition, the counter 43 may output an overflow signal (OF) to the front-end module 52 according to the counted value. However, the counter 53 of FIG. 5 outputs an overflow signal (OF) depending on the bit value of a particular bit (for example, the MSB) set in advance, and also outputs an overflow signal (OF) depending on the bit value of a bit specified by a mode selection signal (sel).

To this end, as shown in FIG. 5, the counter 53 may further include a multiplexer 54 for receiving a mode selection signal (sel). The multiplexer 54 in the counter 53 is connected to specified count bit cells among multiple count bit cells in which respective bit values are stored, receives bit values, selects the bit value of a particular count bit cell according to a mode selection signal (sel), and outputs an overflow signal (OF).

As an example, FIG. 5 shows the case in which the multiplexer 54 selects one of the bit values of the k+m-th bit, the k-th bit, and the k-m-th bit according to the mode selection signal (sel), and outputs an overflow signal (OF) according to the selected bit value. Herein, the k+m-th bit may be the MSB of the N( = k + m)-bit counter 53. According to a mode selection signal (sel), when the multiplexer 54 selects the k+m-th bit, the pixel of FIG. 5 may operate in the same manner as the pixel of FIG. 4.

However, the multiplexer 54 may select the k-th bit or the k-m-th bit according to a mode selection signal (sel) and may output an overflow signal (OF). That is, in FIG. 5, the counter 53 may operate similarly to a variable-bit counter of which a count value for outputting an overflow signal (OF) according to a mode selection signal (sel) is adjusted.

Accordingly, the counter 53 may adjust the number of impulse signals that may be counted until the end of the overflow time (T_{OF}). In addition, when the number of impulse signals that may be counted is adjusted, the number of global clock signals (φ_{GCLK}) that may be measured during the measurement time (T_{MEA}) to which extrapolation is applied may be adjusted. As described above, the pixel structures of FIGS. 4 and 5 are configured to use the single counters 43 and 53 to count the number of impulse signals until the end of the overflow time (T_{OF}) as well as the number of global clock signals (φ_{GCLK}).

Accordingly, when the number of impulse signals that may be counted is adjusted, the number of global clock signals (φ_{GCLK}) that may be counted may be adjusted together. For example, when the multiplexer 54 selects the k-m-th bit on the basis of a mode selection signal (sel) from the k-th bit previously set and the number of impulse signals that may be counted is thus reduced, the overflow time (T_{OF}) for directly counting the number of input photons is shorted, while the measurement time (T_{MEA}) to which extrapolation is applied according to the number of global clock signals (φ_{GCLK}) is increased. In this case, compared to the pixel of FIG. 4 that simply applies extrapolation, the power consumption of the SPAD 51 may be further reduced, but accuracy may be reduced.

When the multiplexer 54 selects the k+m-th bit on the basis of a mode selection signal (sel) and the number of impulse signals that may be counted is increased, the overflow time (T_{OF}) is increased and the measurement time (T_{MEA}) is shortened. In this case, the power consumption of the SPAD 51 may be increased, but accuracy may be improved.

Therefore, a trade-off between power consumption and accuracy may be made by adjusting the overflow time (T_{OF}) according to the purpose of use. Using a variable-bit counter has a problem that the range that counter is capable of counting is changed, causing the overflow time (T_{OF}) and the measurement time (T_{MEA}) to be increased or decreased together and power consumption and accuracy to be thus increased or decreased together. However, as shown in FIG. 5, when the bit for outputting an overflow signal (OF) is configured to be selected, the total countable range of the counter remains unchanged, thereby adjusting the level of power consumption and accuracy.

Herein, the multiplexer 54 has been described as being provided in the counter 53, but the multiplexer 54 may be provided in the front-end module 52 or may be provided separately from the counter 53 or the front-end module 52.

In addition, when the bit for outputting an overflow signal (OF) is not the MSB, the count value of the counter 53 is increased and the bit value of the corresponding bit is changed again and the state of the overflow signal (OF) may be changed. However, this may be simply solved by configuring the front-end module 52 to respond to an overflow signal (OF) only once during exposure time (T_{EXP}) and do not respond thereafter. When initializing the counter 53 after the exposure time (T_{EXP}), the front-end module 52 may be reset to respond to an overflow signal (OF) again.

The control module 20 applies a mode selection signal (sel) to the multiplexer 54. In addition, the pixel value (N_{PH}) is calculated according to Equation 1, but the pixel value (N_{PH}) may be calculated in a different way considering the overflow time (T_{OF}) and the measurement time (T_{MEA}) adjusted according to a mode selection signal (sel). However, multiple timing-gain tables in which pixel values (N_{PH}) according to count values are calculated and stored in advance are provided, and one of the multiple timing-gain tables is selected according to a mode selection signal (sel), and then the pixel value (N_{PH}) corresponding to the count value of the counter 53 is found and obtained.

In some cases, the control module 20 enables the high-order bit (for example, the k+m-th bit) of the counter 53 to be selected by a mode selection signal (sel) in some pixels (for example, the pixels in the region of interest) among the multiple pixels (px) of the pixel array 10 to improve accuracy, while enables the high-order bit (for example, the k-m-th bit) to be selected in the remaining pixels to reduce power consumption, so that power consumption and accuracy are balanced throughout the pixel array 10.

As a result, the SPAD-based image sensor according to the present disclosure is configured to output an overflow signal (OF) by the bit value of a count bit cell variably selected according to a mode selection signal (sel) among multiple count bit cells of the counter 53 provided in each pixel (px), so that power consumption may be reduced or accuracy may be improved for adjustment according to the purpose of use separately.

In the shown embodiments, each of the elements may have functions and capabilities different from the elements described below, and additional elements may be included in addition to the elements described below. In addition, in an embodiment, each element may be implemented using one or more physically distinct devices, one or more processors, or a combination or one or more processors and software, and may not be clearly differentiated from each other in terms of specific operation unlike the illustrated example.

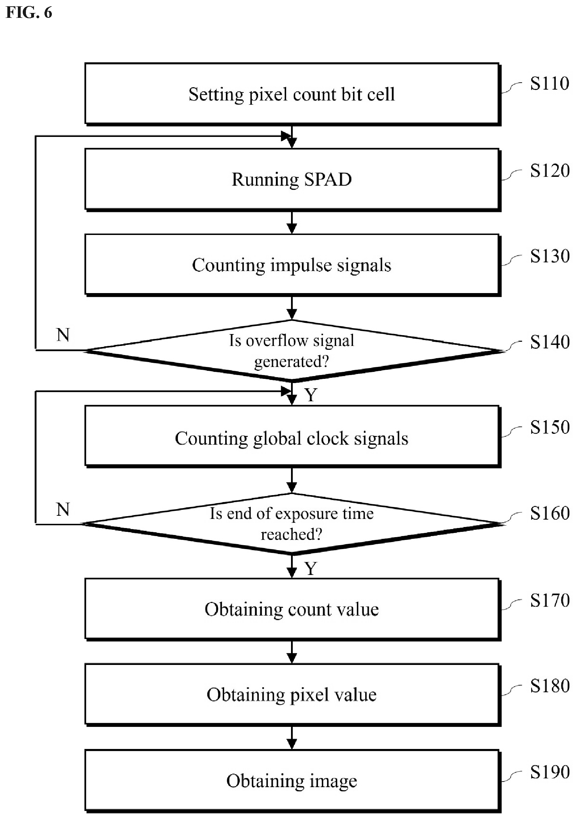

FIG. 6 shows an operation method of an SPAD-based image sensor according to an embodiment.

FIG. 6 illustrates the operation of the image sensor of FIG. 1 on the basis of the configuration of the pixel of FIG. 5. Referring to FIG. 6, first, the control module 20 sets a count bit cell for outputting an overflow signal (OF) among multiple count bit cells of the counter 53 provided in each of the multiple pixels (px) of the pixel array 10, and generates a mode selection signal (sel) according to the set count bit cell, and forwards the mode selection signal to each pixel (px) in step 71. Herein, the control module 20 may perform the same setting for all the pixels (px) of the pixel array 10, or may perform different settings for the respective pixels.

Each pixel (px) includes the SPAD 51, the front-end module 52, the counter 53, and the multiplexer 54. The multiplexer 54 of the pixel (px) to which a mode selection signal (sel) is applied selects a count bit cell according to the mode selection signal (sel) among the multiple count bit cells of the counter 53.

In addition, the SPAD 51 provided in each of the multiple pixels (px) of the pixel array 10 runs in step 72. The control module 20 may control the front-end module 52 to run the SPAD 51. Herein, the control module 20 may perform control such that all the pixels (px) of the pixel array 10 run simultaneously or at different times.

The running SPAD 51 repeatedly generates impulse signals in response to incident photons, the front-end module 52 converts impulse signals generated by the SPAD 51 to pulse signals and forwards the pulse signals to the counter 53, and the counter 53 counts the number of applied pulses in step 73. As the counter 53 counts the number of pulses, the bit value begins to change, starting from the low-order count bit cell among the multiple count bit cell. When the bit value of a set counter bit cell changes, the multiplexer 54 forwards an overflow signal (OF) to the front-end module.

Then, the front-end module 52 determines whether an overflow signal (OF) is generated. When an overflow signal (OF) is not generated, the front-end module 52 continues to run the SPAD 51 and converts the impulse signals generated by the SPAD 51 to pulse signals, and the counter 53 continuously counts the number of pulses in steps 72 and 73.

However, when an overflow signal (OF) is generated, the front-end module 52 stops the running of the SPAD 51 and receives global clock signals (φ_{GCLK}) to generate pulse signals and forward the pulse signals to the counter 53, and the counter 53 counts the number of global clock signals (φ_{GCLK}) instead of impulse signals in step 75.

Afterward, it is determined whether the end of the exposure time (T_{EXP}) is reached in step 76. When the end of the exposure time (T_{EXP}) is not reached, global clock signals (φ_{GCLK}) are still received and continuously counted in step 75. However, when it is determined that the end of the exposure time (T_{EXP}) is reached, the count value currently counted by the counter 53 at each pixel (px) is obtained in step 77.

In addition, the pixel value (N_{PH}) is obtained from the obtained count value in step 78. Herein, the pixel value (N_{PH}) may be calculated according to Equation 1 using the exposure time (T_{EXP}), the number (N_{OF}) of overflows, and the overflow time (T_{OF}) estimated from the measurement time (T_{MEA}) obtained on the basis of the set count bit cell from the count value. However, one of the multiple timing-gain tables in which pixel values (N_{PH}) according to respective count values are calculated and stored in advance may be selected according to the set count bit cell, and then the pixel value (N_{PH}) corresponding to the count value of the counter 53 may be found and obtained.

When the pixel value (N_{PH}) of each of the multiple pixels (px) is obtained, and the pixel values are combined to obtain an image according to light incident on the image sensor in step 79.

Although FIG. 6 discloses that steps are sequentially executed, this is for illustrative purposes only, and those skilled in the art will be able to make and apply various modifications and changes by changing the order disclosed in FIG. 6, by executing one or more processes in parallel, or by adding other processes, without departing from an essential characteristic of the embodiment of the present disclosure.

Although the present disclosure has been described in detail through representative embodiments, those skilled in the art will understand that various modifications and equivalent other embodiments may be made. Accordingly, the true technical protection range of the present disclosure should be determined by the technical spirit of the following claims.

## Claims

1. An image sensor, comprising:
a pixel array including multiple pixels(px),
wherein each(30) of the multiple pixels(px) comprises:
an SPAD(31, 41, 51) configured to detect photons to generate impulse signals;
a counter(33, 43, 53) configured to count the number of pulse signals applied;
a multiplexer(54) configured to select one count bit cell among multiple count bit cells of the counter according to a mode selection signal, and output an overflow signal according to a bit value of the selected count bit cell; and
a front-end module(32, 42, 52) configured to convert the impulse signals to the pulse signals, and convert global clock signals(φ_{GCLK}) to the pulse signals and forward the pulse signals to the counter when the overflow signal is applied.

2. The image sensor of claim 1, wherein the front-end module(32, 42, 52) is configured to run the SPAD(31, 41, 51) during a light detection operation, and stop the running of the SPAD(31, 41, 51) when the overflow signal is applied.

3. The image sensor of claim 1, wherein the front-end module(32, 42, 52) is configured to convert the impulse signals or the global clock signals(φ_{GCLK}) applied until the end of a set exposure time(T_{EXP}) to the pulse signals and forward the pulse signals to the counter(33, 43, 53) during a light detection operation.

4. The image sensor of claim 1, wherein the front-end module(32, 42, 52) is configured to receive the global clock signals(φ_{GCLK}) in response to the overflow signal once until the end of a set exposure time(T_{EXP}).

5. The image sensor of claim 1, wherein the front-end module(32, 42, 52) is configured to initialize the counter(33, 43, 53) after a set exposure time(T_{EXP}).

6. The image sensor of claim 1, wherein the multiplexer(54) is implemented included in either the front-end module(32, 42, 52) or the counter(33, 43, 53).

7. The image sensor of claim 1, further comprising a control module(20),
wherein the control module(20) is configured to generate the mode selection signal(sel), and receive a count value from the counter(33, 43, 53) to obtain a pixel value(N_{PH}) after a set exposure time(T_{EXP}).

8. The image sensor of claim 7, wherein the control module(20) is configured to obtain the number of overflows and an overflow time from the count value according to the count bit cell of the counter selected according to the mode selection signal, and calculate and obtain the pixel value(N_{PH}) according to extrapolation on the basis of the number of overflows and the overflow time obtained and the exposure time(T_{EXP}).

9. The image sensor of claim 7, wherein the control module(20) is configured to select one among multiple timing-gain tables in which pixel values(N_{PH}) according to respective count values are calculated and stored in advance, according to the selected count bit cell, and then obtain the pixel value(N_{PH}) by searching the selected timing-gain table for the pixel value(N_{PH}) corresponding to the count value.

10. The image sensor of claim 7, wherein the control module(20) is configured to generate the mode selection signal by independently setting the count bit cell selected in each of the multiple pixels.

11. An operation method of an image sensor including a pixel array(10) of multiple pixels(px) each including an SPAD(31, 41, 51) and a counter(33, 43, 53), and a control module(20), the operation method comprising:
generating a mode selection signal(sel) for selecting one count bit cell for outputting an overflow signal(OF) among multiple count bit cells of the counter(33, 43, 53);
running the SPAD(31, 41, 51) to count the number of impulse signals generated according to detected photons;
generating the overflow signal(OF) in response to a bit value of the count bit cell selected according to the mode selection signal(sel) in the counter(33, 43, 53); and
counting global clock signals(φ_{GCLK}) when the overflow signal(OF) is generated.

12. The operation method of claim 11, wherein in the counting of the global clock signals(φ_{GCLK}), when the overflow signal(OF) is generated, the running of the SPAD(31, 41, 51) is stopped.

13. The operation method of claim 11, wherein in the counting of the global clock signals(φ_{GCLK}), the global clock signals(φ_{GCLK}) are counted until the end of a set exposure time(T_{EXP}).

14. The operation method of claim 11, wherein in the counting of the global clock signals(φ_{GCLK}), the global clock signals(φ_{GCLK}) are received and counted in response to the overflow signal(OF) once until the end of a set exposure time(T_{EXP}).

15. The operation method of claim 11, wherein in the counting of the global clock signals(φ_{GCLK}), a count value of the counter(33, 43, 53) is initialized after a set exposure time(T_{EXP}).

16. The operation method of claim 11, further comprising
receiving a count value counted by the counter(33, 43, 53) and obtaining a pixel value(N_{PH}) after a set exposure time(T_{EXP}).

17. The operation method of claim 16, wherein in the obtaining of the pixel value(N_{PH}),
the number of overflows and an overflow time are obtained from the count value according to the count bit cell of the counter(33, 43, 53) selected according to the mode selection signal(sel), and
the pixel value(N_{PH}) is calculated and obtained according to extrapolation on the basis of the number of overflows and the overflow time obtained and the exposure time(T_{EXP}).

18. The operation method of claim 16, wherein in the obtaining of the pixel value(N_{PH}),
one among multiple timing-gain tables in which pixel values(N_{PH}) according to respective count values are calculated and stored in advance is selected according to the selected count bit cell, and
the selected timing-gain table is searched for the pixel value(N_{PH}) corresponding to the count value to obtain the pixel value(N_{PH}).

19. The operation method of claim 11, wherein in the generating of the mode selection signal(sel), the mode selection signal(sel) is generated by independently setting the count bit cell selected in each of the multiple pixels(px).
